# EUROPEAN PATENT APPLICATION

(11) **EP 3 334 180 A1**
(43) Date of publication of application: **13.06.2018**
(21) Application number: 16834617.9
(22) Date of filing: 05.08.2016
(51) Int. Cl.: H04R 1/20, F21V 33/00

(54) **ACOUSTO-OPTIC DEVICE AND HEAT DISSIPATION METHOD AND USE THEREOF**

(30) Priority: 07.08.2015 CN 201510484038
(71) Applicant: Tang Band Industries Co., Ltd., Ningbo, Zhejiang 315201 (CN)
(72) Inventor: HUANG, Hsinmin, Ningbo Zhejiang 315201 (CN)
(74) Representative: Klunker IP Patentanwälte PartG mbB
(86) International application number: PCT/CN2016/093561
(87) International publication number: WO 2017/024993

(57) **Abstract**

The present invention provides an acousto-optic device and heat dissipation method and use thereof, which comprises a power-drawing unit (10) and at least one acoustic unit (20). Each of the acoustic units (20) comprises a main vibration speaker (21) electrically connected to the power-drawing unit (10). The power-drawing unit (10) is detachably installed on a power-drawing base (100) to enable the main vibration speaker (21) to draw electric energy from the power-drawing base (100). When the main vibration speaker (21) vibrates to sound in response to an audio signal, the power-10drawing unit (10) installed on the power-drawing base (100) prevents the acoustic units (20) from oscillation, thereby guaranteeing a sound effect of the acousto-optic device.

## Description

### NOTICE OF COPYRIGHT

A portion of the disclosure of this patent document contains material which is subject to copyright protection. The copyright owner has no objection to any reproduction by anyone of the patent disclosure, as it appears in the United States Patent and Trademark Office patent files or records, but otherwise reserves all copyright rights whatsoever.

### BACKGROUND OF THE PRESENT INVENTION

### FIELD OF INVENTION

The present invention relates to an acousto-optic device, and, in particular, to an acousto-optic device and heat dissipation method and use thereof.

### DESCRIPTION OF RELATED ARTS

In recent years, there is a demand for an integrated electronic device of sound and light in the market, which requires the device to be able to produce sound and light at the same time. For instance, there is an acoustics device in the market that integrated a speaker and a luminous element. The operating principle of this acoustics device is to connect the acoustics device to an audio device and the audio signal sent by the audio device can be responded by the speaker for generating sound. Meanwhile, the luminous element can generate light based on a predetermined pattern or the real-time phase of the audio signal, so as to enhance the audio atmosphere. Unfortunately, light produced by the luminous element of such acoustics device in the market can only serve to foil the atmosphere, rather than to provide an effective illumination.

Besides, conventional acoustics devices usually have to be provided on the ground or countertop to be utilized. Such usage cannot secure the acoustics device at a place. Thus, when the speaker of the acoustics device stirs the air to sound in response to an audio signal input, the acoustics device will oscillate or even shift, rendering noise of the speaker and severely impact the sound quality and effect of the acoustics device. Conventional acoustics device obtains electric power by inserting a pin provided on a wire terminal into a socket. Such way of obtaining electric power restricts the flexibility of utilization of conventional acoustics device to a great extent. In addition, most buildings tend to reserve several lamp mounting bases or electric sockets on the ceiling when they were built or decorated, so as to mount or provide electric power to the lamps and to allow other power devices to obtain electric power by plugging into the electric sockets. The present inventor of the present invention aims to provide an acousto-optic device capable of utilizing these lamp mounting bases for generating sound and light.

### SUMMARY OF THE PRESENT INVENTION

An advantage of the present invention is to provide an acousto-optic device and heat dissipation method and use thereof, wherein the acousto-optic device can be arranged on a preset power-drawing base, so as not only to be affixed on the power-drawing base, but also to obtain electric power from the power-drawing base.

An advantage of the present invention is to provide an acousto-optic device and heat dissipation method and use thereof, wherein the acousto-optic device comprises a power-drawing unit and an acoustic unit electrically connected with power-drawing unit, such that when the power-drawing unit is mounted on the power-drawing base, the acoustic unit can obtain electric power from the power-drawing base through the power-drawing unit.

An advantage of the present invention is to provide an acousto-optic device and heat dissipation method and use thereof, wherein the acousto-optic device comprises an illumination unit electrically connected with power-drawing unit, such that when the power-drawing unit is mounted on the power-drawing base, the illumination unit can obtain electric power from the power-drawing base through the power-drawing unit.

An advantage of the present invention is to provide an acousto-optic device and heat dissipation method and use thereof, wherein the acoustic unit and the illumination unit can both obtain electric power from the power-drawing base through the power-drawing unit at the same time, so as to allow the acousto-optic device to generate illumination light and sound at the same time.

An advantage of the present invention is to provide an acousto-optic device and heat dissipation method and use thereof, wherein the acousto-optic device is affixed on the power-drawing base through the power-drawing unit, such that when the acoustic unit stirs the air to sound in response to an audio signal input, the acousto-optic device will not oscillate, which makes the sound effect generated by the acousto-optic device purer.

An advantage of the present invention is to provide an acousto-optic device and heat dissipation method and use thereof, wherein the acousto-optic device is affixed on the power-drawing base through the power-drawing unit, such that the utilization of the acousto-optic device does not have to occupy ground or countertop space, which can save space.

An advantage of the present invention is to provide an acousto-optic device and heat dissipation method and use thereof, wherein the service states of the illumination unit and the acoustic unit can also be selected. For example, the user can utilize either of the illumination unit or the acoustic unit alone or utilize both the illumination unit and the acoustic unit at the same time.

An advantage of the present invention is to provide an acousto-optic device and heat dissipation method and use thereof, wherein the illumination unit and the acoustic unit are integrated, so as to reduce the costs of illuminating and sounding for the user.

An advantage of the present invention is to provide an acousto-optic device and heat dissipation method and use thereof, wherein the acoustic unit is hidden in the inside of the illumination unit, such that the acoustic unit can be protected by the illumination unit and the exterior shape of the acousto-optic device can be decided by the exterior shape of the illumination unit, which can beautify the exterior shape of the acousto-optic device through changing the exterior shape of the illumination unit.

An advantage of the present invention is to provide an acousto-optic device and heat dissipation method and use thereof, wherein the illumination unit provides a housing and the acoustic unit is hidden in the internal environment of the housing, such that the exterior shape of the acousto-optic device is decided by the exterior shape of the housing. For example, the exterior shape of the housing can be like an exterior shape of conventional lamp.

An advantage of the present invention is to provide an acousto-optic device and heat dissipation method and use thereof, wherein when the illumination unit and the acoustic unit are both in the service state, the acoustic unit is also utilized to balance the air pressure between the external environment and the internal environment of the housing, so as to make the acousto-optic device more reliable.

An advantage of the present invention is to provide an acousto-optic device and heat dissipation method and use thereof, wherein the acoustic unit can fast transfer the heat generated by the illumination unit at work from the internal environment to the external environment of the housing, so as to decrease the temperature of the internal environment of the housing, such that the acoustic unit can enhance the heat dissipation performance of the acousto-optic device.

An advantage of the present invention is to provide an acousto-optic device and heat dissipation method and use thereof, wherein the housing comprises at least one channel communicating the internal environment and the external environment of the housing, such that the heat generated by the illumination unit at work can be transferred between the internal environment and the external environment of the housing through the channel, so as to decrease the temperature of the internal environment of the housing.

An advantage of the present invention is to provide an acousto-optic device and heat dissipation method and use thereof, wherein the acoustic unit provides a main vibration speaker, the housing provides a sound channel, and the main vibration speaker is arranged in the internal environment of the housing and corresponded to the sound channel, such that when the main vibration speaker vibrates to sound in response to an audio signal input, the sound can radiate from the internal environment to the external environment of the housing through the sound channel.

An advantage of the present invention is to provide an acousto-optic device and heat dissipation method and use thereof, wherein the acoustic unit further provides a passive vibrator and a vibration chamber, wherein the main vibration speaker and the passive vibrator share the vibration chamber, wherein the main vibration speaker sounds in response to an audio signal input, while the passive vibrator vibrates in response to the vibration of the main vibration speaker so as to produce a subsidiary sound effect to enhance the low frequency sound effect of the acoustic unit.

An advantage of the present invention is to provide an acousto-optic device and heat dissipation method and use thereof, wherein when the acoustic unit is in the service state, the passive vibrator in the housing will stir the air in the internal environment to pass through the channels to interchange with the air of the external environment, so as to enhance the heat dissipation performance of the acousto-optic device.

Another advantage of the present invention is to provide an acousto-optic device and heat dissipation method and use thereof, wherein the total ventilation volume of the channels is greater than the air volume of the internal environment stirred by the passive vibrator when the acoustic unit is in the service state, such that the design of the channels will not cause wind noise on the acousto-optic device, which avoids the sounding acousto-optic device from whistling.

According to another aspect of the present invention, the present invention provides an acousto-optic device, comprising:
a power-drawing unit; and
at least an acoustic unit, wherein each of said acoustic units comprises a main vibration speaker electrically connected with the power-drawing unit, wherein said power-drawing unit is detachably installed on a power-drawing base to allow said main vibration speaker to draw electric energy therefrom, wherein when said main vibration speaker vibrates to sound in response to an audio signal, said power-drawing unit installed on the power-drawing base prevents said acoustic units from oscillation, so as to guarantee the sound effect of said acousto-optic device.

According to an embodiment of the present invention, the acousto-optic device further comprises an illumination unit comprising a light emitting unit electrically connected with the power-drawing unit.

According to an embodiment of the present invention, the power-drawing unit and the light emitting unit are respectively arranged on the main vibration speaker.

According to an embodiment of the present invention, the acoustic unit further comprises at least a passive vibrator and a vibration chamber, wherein each the passive vibrator and the main vibration speaker share the vibration chamber, wherein when the main vibration speaker vibrates to sound in response to an audio signal, each the passive vibrator vibrates in response to the vibration of the main vibration speaker, so as to produce a subsidiary sound effect.

According to an embodiment of the present invention, the acoustic unit further comprises a speaker frame, wherein the main vibration speaker and each the passive vibrator are respectively arranged on the speaker frame, so as to define the vibration chamber among the main vibration speaker, each the passive vibrator, and the speaker frame, wherein the power-drawing unit is arranged on the speaker frame.

According to an embodiment of the present invention, the acousto-optic device further comprises a mounting body, wherein the power-drawing unit, the main vibration speaker, and the light emitting unit are respectively arranged on the mounting body.

According to an embodiment of the present invention, the acousto-optic device further comprises an illumination unit, wherein the illumination unit comprises a housing defining an internal environment and an external environment and providing a sound channel, wherein the sound channel communicates the internal environment and the external environment, wherein the power-drawing unit is arranged on the housing and located in the external environment, wherein the main vibration speaker is arranged in the internal environment of the housing and corresponded to the sound channel.

According to an embodiment of the present invention, the housing further comprises at least a channel formed thereon, wherein each the channel respectively communicates the internal environment and the external environment, wherein the acoustic unit further comprises a passive vibrator and a vibration chamber, wherein the passive vibrator is arranged in the internal environment of the housing, wherein the passive vibrator and the main vibration speaker share the vibration chamber, wherein when the main vibration speaker vibrates to sound in response to an audio signal input, the passive vibrator vibrates in response to the vibration of the main vibration speaker, so as to produce a subsidiary sound effect, wherein the subsidiary sound effect produced by the passive vibrator radiates from the internal environment to the external environment through each the channel.

According to an embodiment of the present invention, the housing has a mounting bed arranged on the inner wall thereof, wherein the acoustic unit comprises a speaker frame mounted on the mounting bed, wherein the main vibration speaker and the passive vibrator are respectively arranged on the speaker frame, so as to define the vibration chamber among the main vibration speaker, the passive vibrator, and the speaker frame.

According to an embodiment of the present invention, the illumination unit further comprises a light emitting unit arranged on the inner wall of the housing or the speaker frame and electrically connected with the power-drawing unit.

According to an embodiment of the present invention, the housing further comprising:
a transparent lamp shell; and
a mounting shell, wherein the mounting shell comprises the channels, wherein the speaker frame is arranged in the mounting shell or in the lamp shell, wherein the power-drawing unit is arranged outside of the mounting shell, wherein the lamp shell is mounted on the mounting shell, such that the acoustic unit and the light emitting unit are provided in the internal environment defined between the lamp shell and the mounting shell, wherein light generated by the light emitting unit passes through the lamp shell to radiate from the internal environment to the external environment.

According to an embodiment of the present invention, the housing further comprising:
a transparent lamp shell; and
a mounting shell, wherein the mounting shell comprises at least two bracing columns arranged thereon, wherein the speaker frame is arranged in the mounting shell or in the lamp shell, wherein the power-drawing unit is arranged outside of the mounting shell, wherein the lamp shell is mounted on the bracing columns of the mounting shell, so as to define the channel between the adjacent bracing columns, such that the acoustic unit and the light emitting unit are provided in the internal environment defined between the lamp shell and the mounting shell, wherein light generated by the light emitting unit passes through the lamp shell to radiate from the internal environment to the external environment.

According to an embodiment of the present invention, the housing further comprising:
a transparent lamp shell, wherein the lamp shell comprises at least two bracing columns arranged thereon; and
a mounting shell, wherein the speaker frame is arranged in the mounting shell or in the lamp shell, wherein the power-drawing unit is arranged outside of the mounting shell, wherein the mounting shell is mounted on the bracing columns of the lamp shell, so as to define the channel between the adjacent bracing columns, such that the acoustic unit and the light emitting unit are provided in the internal environment defined between the lamp shell and the mounting shell, wherein light generated by the light emitting unit passes through the lamp shell to radiate from the internal environment to the external environment.

According to an embodiment of the present invention, the housing further comprising:
a transparent lamp shell;
a mounting shell, wherein the power-drawing unit is arranged outside of the mounting shell; and
a bracing member, comprising at least two bracing columns arranged on a side thereof, wherein the mounting shell is arranged on another side of the bracing member, wherein the speaker frame is arranged in the lamp shell or in the bracing member, wherein the lamp shell is mounted on the bracing columns of the bracing member, so as to define the channel between the adjacent bracing columns, such that the acoustic unit and the light emitting unit are provided in the internal environment defined between the lamp shell and the bracing member, wherein light generated by the light emitting unit passes through the lamp shell to radiate from the internal environment to the external environment.

According to an embodiment of the present invention, the housing further comprising:
a transparent lamp shell, wherein the lamp shell comprises at least two bracing columns arranged thereon;
a mounting shell, wherein the power-drawing unit is arranged outside of the mounting shell; and
a bracing member, wherein the mounting shell is arranged on a side of the bracing member, wherein another side of the bracing member is mounted on the bracing columns of the lamp shell, so as to define the channel between adjacent bracing columns, such that the speaker frame is arranged in the lamp shell or in the bracing member, such that the acoustic unit and the light emitting unit are provided in the internal environment defined between the lamp shell and the bracing member, wherein light generated by the light emitting unit passes through the lamp shell to radiate from the internal environment to the external environment.

According to an embodiment of the present invention, the bracing columns form a first bracing column set and a second bracing column set, wherein each the bracing column of the first bracing column set and each the bracing column of the second bracing column set are alternately arranged, wherein the dimensions of the bracing columns of the first bracing column set gradually becomes smaller from the direction of the internal environment to the direction of the external environment, while the dimensions of the bracing columns of the second bracing column set gradually becomes larger from the direction of the internal environment to the direction of the external environment.

According to an embodiment of the present invention, the acousto-optic device further comprises a circuit unit arranged in the internal environment, wherein the circuit unit comprises a circuit component electrically connected with the power-drawing unit, the main vibration speaker, and the light emitting unit respectively. According to an embodiment of the present invention, the circuit unit further comprises an amplifier component connected with the main vibration speaker.

According to another aspect of the present invention, the present invention further provides a heat dissipation method of an acousto-optic device, comprising the following steps:
(i) adjacently arranging a light emitting unit and an acoustic unit in an internal environment of a housing, wherein heat generated by the light emitting unit at work increases the temperature of the internal environment; and
(ii) stirring the air of the internal environment to pass through at least a channel of the housing to interchange with the air of an external environment of the housing when the acoustic unit responds to the audio signal input, so as to decrease the temperature of the internal environment and therefore implement heat dissipation of the acousto-optic device.

According to an embodiment of the present invention, the light emitting unit is arranged on a speaker frame of one the acoustic unit in the step (i), such that when a main vibration speaker of the acoustic unit vibrate in response to an audio signal input, a passive vibrator of the acoustic unit can vibrate in response to the vibration of the main vibration speaker, so as to utilize the passive vibrator to stir the air of the internal environment to pass through each the channel to interchange with the air of an external environment in the step (ii).

According to an embodiment of the present invention, the main vibration speaker and the passive vibrator are arranged on the opposite side of the speaker frame, wherein the light emitting unit is adjacent to the passive vibrator.

According to an embodiment of the present invention, the main vibration speaker and the passive vibrator share a vibration chamber, so as to allow the passive vibrator to vibrate in response to the vibration of the main vibration speaker.

Still further objects and advantages will become apparent from a consideration of the ensuing description and drawings.

These and other objectives, features, and advantages of the present invention will become apparent from the following detailed description, the accompanying drawings, and the appended claims.

### BRIEF DESCRIPTION OF THE DRAWINGS

FIG. 1 is a perspective view from a visual angle of the acousto-optic device according to a first preferred embodiment of the present invention.
FIG. 2 is a perspective view illustrating a service state of the acousto-optic device according to the above preferred embodiment of the present invention.
FIG. 3 is a perspective view of the acousto-optic device according to an alternative mode of the above preferred embodiment of the present invention.
FIG. 4 is a perspective view of the acousto-optic device according to another alternative mode of the above preferred embodiment of the present invention.
FIG. 5 is a perspective view illustrating a service state of the acousto-optic device according to the above preferred embodiment of the present invention.
FIG. 6 is a sectional view of the acousto-optic device according to a second preferred embodiment of the present invention.
FIG. 7 is an exploded view of the acousto-optic device according to a third preferred embodiment of the present invention.
FIG. 8 is a sectional view of the acousto-optic device according to the above preferred embodiment of the present invention.
FIG. 9 is a sectional view of the acousto-optic device according to an alternative mode of the above preferred embodiment of the present invention.
FIG. 10 is a perspective view of the acousto-optic device according to a fourth preferred embodiment of the present invention.
FIG. 11 is an exploded view of the acousto-optic device according to the above preferred embodiment of the present invention.
FIG. 12 is a sectional view of the acousto-optic device according to the above preferred embodiment of the present invention.
FIG. 13 is a perspective view of a bracing member of the acousto-optic device according to the above preferred embodiment of the present invention.
FIG. 14 is a perspective view illustrating a service state of the acousto-optic device according to the above preferred embodiment of the present invention.
FIG. 15 is a flow diagram of a method for the acousto-optic device to generate light and sound according to the above preferred embodiment of the present invention.
FIG. 16 is a flow diagram of an application method of the acousto-optic device according to the above preferred embodiment of the present invention.
FIG. 17 is a flow diagram of a heat dissipation method of the acousto-optic device according to the above preferred embodiment of the present invention.

### DETAILED DESCRIPTION OF THE PREFERRED EMBODIMENT

According to the appended claims and the disclosed specification, the technical solutions of the present invention are as follows.

Those skilled in the art should understand that, in the disclosure of the present invention, terminologies of "longitudinal," "lateral," "upper," "lower," "front," "back," "left," "right," "perpendicular," "horizontal," "top," "bottom," "inner," "outer," and more that indicate relations of direction or position are based on the relations of direction or position shown in the appended drawings, which is only for ease of describing the present invention and simplifying the description, rather than to indicate or imply that the referred device or element has to apply specific direction or to be operated or structured in specific direction. Therefore the above-mentioned terminologies shall not be interpreted as confine to the present invention.

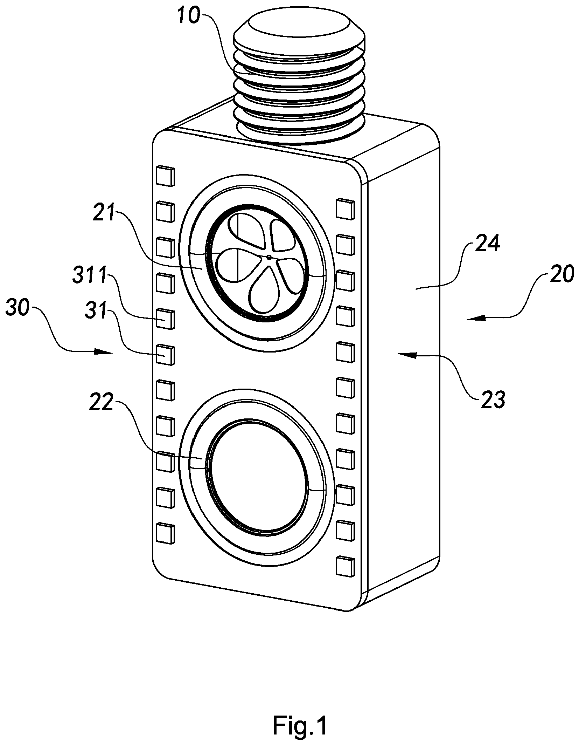

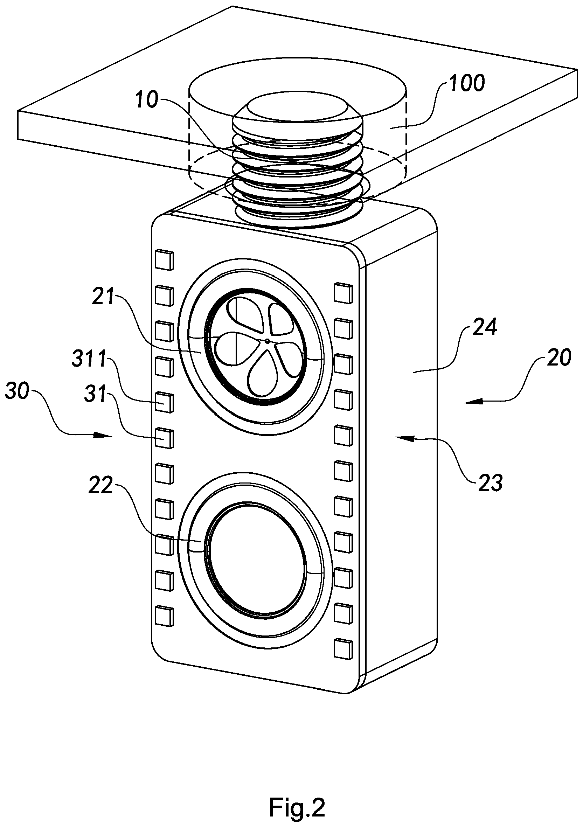

It is understandable that terminologies of "a" or "an" should be interpreted as "at least one" or "one or more." In other words, in one embodiment, the quantity of an element can be one, but in another embodiment, the quantity of the element can be several. Hence, the terminologies of "a" or "an" shall not be considered as a limit of quantity. Referring to Figs. 1-2 of the drawings of the present invention, the acousto-optic device according to a first preferred embodiment of the present invention will be disclosed and illustrated in the following description. The acousto-optic device of the present invention is mounted on a power-drawing base 100, such that the acousto-optic device is able to not only be affixed on the power-drawing base 100, but also obtain external electric power from the power-drawing base 100.

According to an embodiment of the acousto-optic device of the present invention, the power-drawing base 100 can be a lamp mounting base. For example, the power-drawing base 100 is a lamp socket preset in the building for mounting lamp. For instance, the power-drawing base 100 can be embedded on the ceiling of the building or on the wall of the building. Therefore, when the acousto-optic device is mounted on the power-drawing base 100, the sound or light generated by the acousto-optic device can both provided from the top of the user, such that the sound or light generated by the acousto-optic device can evenly radiate in the used space of the building. Besides, the acousto-optic device is mounted on the power-drawing base 100 for being affixed thereon, such that when the acousto-optic device sound by stirring the air, the acousto-optic device will not oscillate, which guarantees the purity of the sound effect of the sound generated by the acousto-optic device.

Specifically speaking, the acousto-optic device comprises a power-drawing unit 10 and an acoustic unit 20 electrically connected with the power-drawing unit 10, wherein the power-drawing unit 10 is mounted on the power-drawing base 100, so as to affix the acousto-optic device on the power-drawing base 100 and allow the acoustic unit 20 to obtain external electric power from the power-drawing base 100 through the power-drawing unit 10. It is worth mentioning that according to the acousto-optic device of the present invention, there is no wire between the power-drawing unit 10 and the acoustic unit 20. Therefore, when the sound power-drawing unit 10 is mounted on the power-drawing base 100, the position of the acoustic unit 20 is fixed, such that when the acoustic unit 20 stirs the air to sound in response to an audio signal input, the acoustic unit 20 will not oscillate, such that the sound quality of the acoustic unit 20 of the acousto-optic device can be enhanced.

According to a preferred implementation of the present invention, the power-drawing unit 10 is detachably mounted on the power-drawing base 100. By this way, the user may replace the acousto-optic devices on the power-drawing base 100. For example, when the acousto-optic device is broken, the user may replace it with a functional acousto-optic device. Perhaps, if the acousto-optic device does not meet the demand of the user, he may replace it with other suitable acousto-optic device. Therefore, the flexibility of utilization of the acousto-optic device can be enhanced.

It is worth mentioning that the connection modes of the power-drawing unit 10 and the power-drawing base 100 shall not limit the content and scope of the acousto-optic device of the present invention. For instance, according to a preferred implementation of the present invention, the power-drawing unit 10 can be connected to the power-drawing base 100 through a thread engagement. Nevertheless, according to another preferred implementation of the present invention, the power-drawing unit 10 can also be connected to the power-drawing base 100 through a buckling connection. That is to say, the type of the power-drawing unit 10 of the acousto-optic device of the present invention can be decided by the user based on the type of the power-drawing base 100.

The acoustic unit 20 stirs the air to vibrate it to sound in response to an audio signal input. Contrasting to conventional acoustics device, the acousto-optic device of the present invention is affixed on the power-drawing base 100 through the power-drawing unit 10. Hence, when the acoustic unit 20 is stirring the air in response to the audio signal input, the acoustic unit 20 will not render oscillation to the acousto-optic device. By this way, it can avoid noise occurring in the sound generated by the acoustic unit 20, so as to ensure the purity of the sound effect of the acousto-optic device. The acousto-optic device of the present invention utilizes the power-drawing unit 10 to affix the acousto-optic device on the power-drawing base 100, so as to ensure that there will not be noise occurred in the sound effect generated by the acoustic unit 20. This is beyond the anticipation of conventional speakers. Besides, this way of the present invention is especially useful for guaranteeing the sound effect of the acousto-optic device.

In addition, the usage of the acousto-optic device that suspends it on the upper space of the building, such as hanging the acousto-optic device on the ceiling of the building, allows the acousto-optic device not to occupy ground or countertop space. Moreover, the sound generated by the acoustic unit 20 of the acousto-optic device can radiate around from the user's upper space, which makes the spread of the sound more evenly in the room and allows the user to gain excellent audio experience at anywhere in the room.

The acoustic unit 20 further comprises a main vibration speaker 21 electrically connected with the power-drawing unit 10, so as to allow the main vibration speaker 21 to obtain external electric power from the power-drawing base 100 through the power-drawing unit 10 and, consequently, to stir the air to vibrate it to sound in response to an audio signal input.

The acoustic unit 20 further comprises a passive vibrator 22 and a vibration chamber 23. The main vibration speaker 21 and the passive vibrator 22 share the vibration chamber 23. When the main vibration speaker 21 stirs the air to vibrate it to sound in response to an audio signal input, the passive vibrator 22 vibrates in response to the vibration of the main vibration speaker 21, so as to produce a subsidiary sound effect, such that the passive vibrator 22 can serve to enhance the low frequency sound effect of the acoustic unit 20.

In addition, the acoustic unit 20 further comprises a speaker frame 24, wherein the main vibration speaker 21 and the passive vibrator 22 are respectively arranged on the speaker frame 24, so as to define the vibration chamber 23 among the main vibration speaker 21, the passive vibrator 22, and the speaker frame 24 and to have the main vibration speaker 21 and the passive vibrator 22 share the vibration chamber 23. In other words, the speaker frame 24 can integrate the main vibration speaker 21 and the passive vibrator 22, so as to define the vibration chamber 23 among the main vibration speaker 21, the passive vibrator 22, and shape the speaker frame 24, which then makes the acoustic unit 20. According to this preferred implementation of the present invention, the power-drawing unit 10 can be arranged on the speaker frame 24. Therefore, after the power-drawing unit 10 is mounted on the power-drawing base 100 and the acoustic unit 20 stirs the air to sound in response to an audio signal input, the acoustic unit 20 will not oscillate or shake.

It is worth mentioning that the main vibration speaker 21 and the passive vibrator 22 can be arranged on the same side of the speaker frame 24 or on the opposite sides of the speaker frame 24. According to the preferred implementation of the present invention illustrated in Fig. 1, the main vibration speaker 21 and the passive vibrator 22 are arranged on the same side of the speaker frame 24.

Besides, person skilled in the art should be able to understand that the acousto-optic device of the present invention may not generate light, but generate sound by the acoustic unit 20 only.

Further, the acousto-optic device can further comprise an illumination unit 30electrically connected with the power-drawing unit 10. When the power-drawing unit 10 is mounted on the power-drawing base 100, the illumination unit 30 can obtain external electric energy from the power-drawing base 100 through the power-drawing unit 10 for generating light. It is worth mentioning that, according to this preferred implementation of the present invention, when the power-drawing unit 10 is mounted on the power-drawing base 100, the acoustic unit 20 and the illumination unit 30 can obtain external electric power from the power-drawing base 100 through the power-drawing unit 10 at the same time, so as to allow the acousto-optic device to generate sound and light at the same time. Person skilled in the art should be able to understand that the service state of the acousto-optic device can be operated and controlled. For instance, either one or both of the acoustic unit 20 and the illumination unit 30 of the acousto-optic device can be selectively turned into the service state, wherein the present invention shall not be limited here.

The illumination unit 30 further comprises a light emitting unit 31 electrically connected with the power-drawing unit 10, so as to generate light after obtaining external electric energy from the power-drawing base 100 through the power-drawing unit 10. It is worth mentioning that the light generated by the light emitting unit 31 can be illumination light or aura light. The operating modes of the light emitting unit 31 will be disclosed and described in detail later in the present invention. Preferably, according to this preferred implementation of the present invention, the light emitting unit 31 can be arranged on the acoustic unit 20. For example, the light emitting unit 31 can be arranged on the speaker frame 24 of the acoustic unit 20.

Further, the light emitting unit 31 comprises at least a light emitting element 311. The light emitting elements 311 are respectively arranged on the speaker frame 24. According to the embodiment illustrated in Fig. 1, the light emitting elements 31 of the light emitting unit 31 can be arranged into two rows. The two rows of the light emitting elements 31 are respectively symmetrically arranged on the two sides of the speaker frame 24. Nonetheless, person skilled in the art should be able to understand that the arrangement of the light emitting elements 311 of the light emitting unit 31 shall not limit the content and scope of the present invention. Preferably, the light emitting elements 311 can be LED light emitting elements.

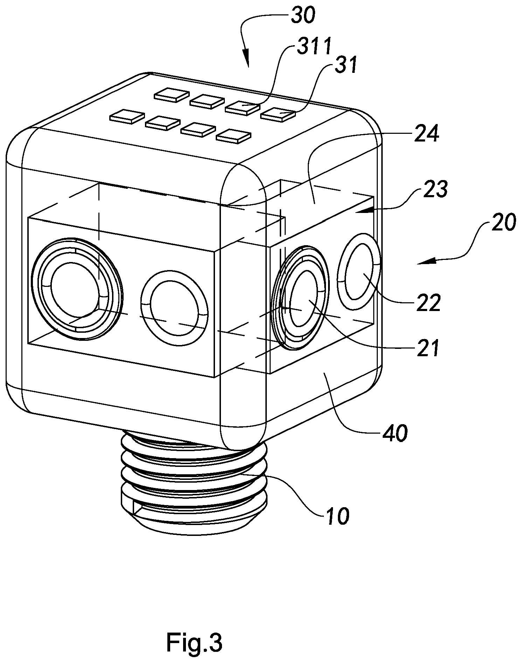

Figure 3 illustrated the acousto-optic device according to an alternative mode of the above first preferred embodiment of the present invention. Unlike the above implementation of the above first preferred embodiment, the power-drawing unit 10 is not provided on the acoustic unit 20. Specifically speaking, the acousto-optic device further comprises a mounting body 40, wherein the power-drawing unit 10, the acoustic unit 20, and the illumination unit 30 are respectively arranged on the mounting body 40, so as to form the acousto-optic device. In addition, according to this implementation, the quantity of the acoustic unit 20 provided on the mounting body 40 may be unlimited. For instance, in a practical application of the acousto-optic device, the quantity of the acoustic unit 20 can be one, two, or more.

When the power-drawing unit 10 is mounted on the power-drawing base 100 and the acoustic unit 20 stirs the air to sound in response to an audio signal input, the acoustic unit 20 will not oscillate because of the mounting body 40, such that the sound quality of the acousto-optic device can be ensured. In other words, the mounting body 40 can integrate the power-drawing unit 10, the acoustic unit 20, and the illumination unit 30, so as to form the acousto-optic device.

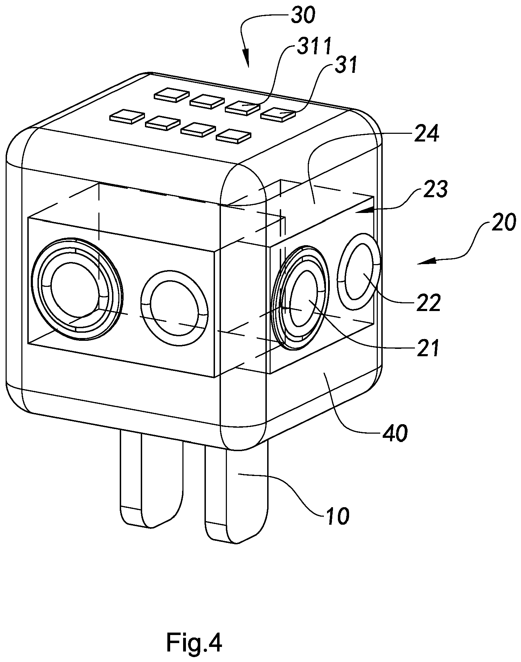

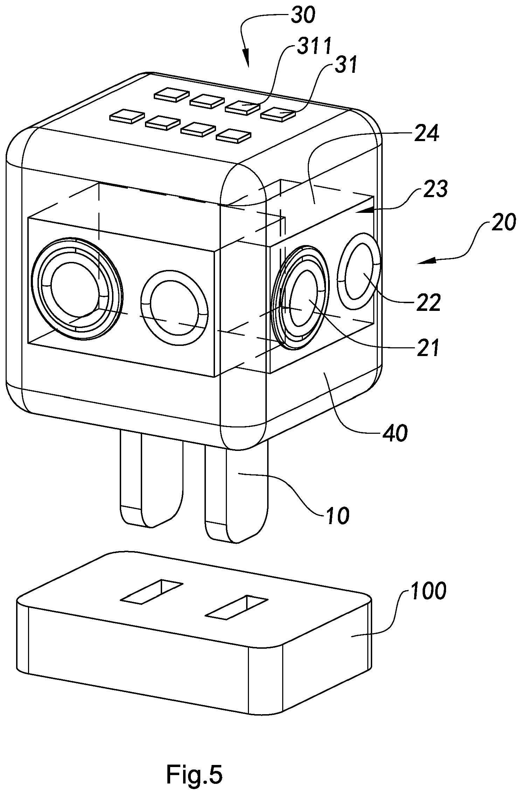

Figure 4-5 illustrated the acousto-optic device according to another alternative mode of the above first preferred embodiment of the present invention. Unlike the above implementation that embodied the power-drawing unit 10 as a structure matching with the lamp mounting base, the power-drawing unit 10 according to this alternative mode of the present invention is embodied as a structure matching with an electric socket, such that the power-drawing unit 10 can be mounted on the power-drawing base 100 that is embodied as an electric socket, so as to obtain electric power therefrom. It is understandable that Figs. 4-5 only illustrated an embodiment of the acousto-optic device. The power-drawing unit 10 of the acousto-optic device can also be embodied as a two pin plug, three pin plug, or etc. based on the needs, wherein the present invention shall not be limited here.

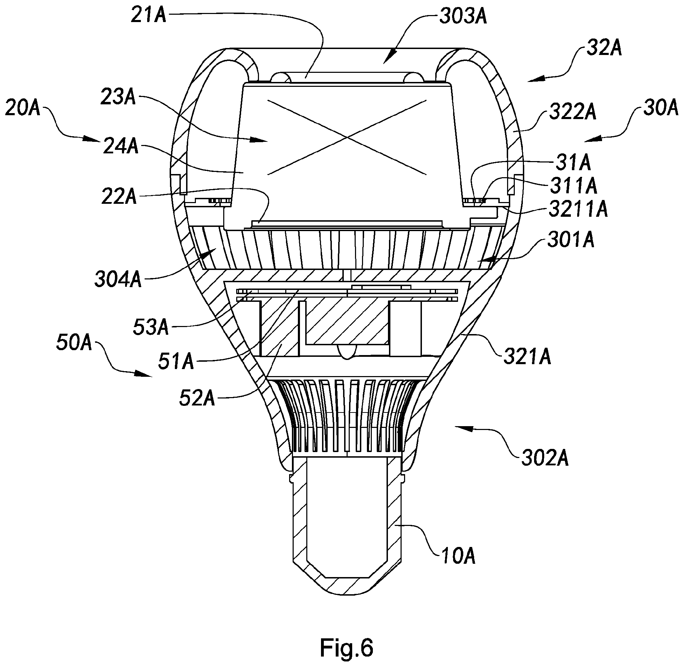

Referring to Fig. 6 of the drawings of the present invention, the acousto-optic device according to a second preferred embodiment of the present invention will be disclosed and illustrated in the following description. The acousto-optic device comprises a power-drawing unit 10A, an acoustic unit 20A, and an illumination unit 30A. The power-drawing unit 10A and the acoustic unit 20A are respectively arranged on the illumination unit 30A. The acoustic unit 20A and the illumination unit 30A are respectively electrically connected with the power-drawing unit 10A. The power-drawing unit 10A is detachably mounted on a power-drawing base 100A so as to obtain external electric power from the power-drawing base 100A to actuate the acoustic unit 20A and the illumination unit 30A into the service state. Person skilled in the art should be able to understand that acoustic unit 20A and the illumination unit 30A can share one electric circuit, such that the stability and reliability of the acousto-optic device can be enhanced.

Further, the acousto-optic device comprises a circuit unit 50A electrically connected with the power-drawing unit 10A. The acoustic unit 20A and the illumination unit 30A are respectively electrically connected with the circuit unit 50A, such that when the power-drawing unit 10A is mounted on the power-drawing base 100A to obtain external electric power, the circuit unit 50A can distribute and supply the electric power from the power-drawing unit 10A to the acoustic unit 20A and the illumination unit 30A respectively, so as to allow the acoustic unit 20A to generate sound and allow the illumination unit 30A to generate light.

The illumination unit 30A further comprises a light emitting unit 31A and a housing 32A. The housing 32A defines an internal environment 301A and an external environment 302A and further provides a sound channel 303A communicating the internal environment 301A and the external environment 302A of the housing 32A.

The acoustic unit 20A comprises a main vibration speaker 21 A. The main vibration speaker 21A and the light emitting unit 31A are respectively arranged in the housing 32A. The main vibration speaker 21A corresponds to the sound channel 303A of the housing 32A. The power-drawing unit 10A is arranged on the housing 32A and located outside of the housing 32A. In other words, the main vibration speaker 21 A and the light emitting unit 31A are both located in the internal environment 301A of the housing 32A. Besides, the power-drawing unit 10A is located in the external environment 302A of the housing 32A. When the power-drawing unit 10A is mounted on the power-drawing base 100A to obtain external electric power, the light emitting unit 31A can generate light and radiate it from the internal environment 301A of the housing 32A to the external environment 302A through part of the housing 32A. Correspondingly, the main vibration speaker 21A stirs the air to vibrate to sound in response to an audio signal input. The sound produced by the main vibration speaker 21A will radiate from the internal environment 301A of the housing 32A to the external environment 302A through the sound channel 303A of the housing 32A.

Referring to Fig. 6, the housing 32A further comprises a mounting shell 321A and a lamp shell 322A mounted on the mounting shell 321A, wherein the sound channel 303A is arranged on the lamp shell 322A. According to this preferred implementation of the present invention, the power-drawing unit 10A, the main vibration speaker 21 A, and the light emitting unit 31A are respectively arranged on the mounting shell 321A. Besides, after the main vibration speaker 21 A and the light emitting unit 31 A are arranged on the mounting shell 321 A, the lamp shell 322A will be mounted on the mounting shell 321 A, so as to have the housing 32A define the internal environment 301A and the external environment 302A. As a result, the main vibration speaker 21A and the light emitting unit 31 A will be located in the internal environment 301 A of the housing 32A, while the power-drawing unit 10A will be located in the external environment 302A of the housing 32A.

It is worth mentioning that the power-drawing unit 10A, the main vibration speaker 21A, and the light emitting unit 31A can be respectively arranged at different positions of the mounting shell 321 A. For instance, according to this preferred implementation of the present invention, the power-drawing unit 10A can be arranged on an end of the mounting shell 321A, while the main vibration speaker 21A and the light emitting unit 31 A are respectively arranged on another end of the mounting shell 321 A. For instance, according to the embodiment illustrated in Fig. 6, the main vibration speaker 21 A and the light emitting unit 31 A provided on the housing 32A are arranged on the upper end of the mounting shell 321A, whereas the power-drawing unit 10A is arranged on the lower end of the mounting shell 321 A.

Further, the light emitting unit 31A comprises at least a light emitting element 311A. The light emitting elements 311A can be surroundingly arranged around the main vibration speaker 21 A. The lamp shell 322A is arranged along the light path of the light emitting elements 311A of the light emitting unit 31A, such that the light generated by the light emitting elements 311A of the light emitting unit 31A can pass through the lamp shell 322A to radiate from the internal environment 301A to the external environment 302A.

Correspondingly, the sound generated by the vibration of the air stirred by the main vibration speaker 21A in response to an audio signal input can radiate from the internal environment 301A to the external environment 302A of the housing 32A through the sound channel 303A.

It is worth mentioning that the mounting shell 321A can be made of material with better heat dissipation quality, such that heat generated along with the light by the light emitting elements 311A of the light emitting unit 31A can be transmitted and radiated through the mounting shell 321A. For example, the mounting shell 321A can be made of materials like metal, aluminum alloy, and etc. It is understandable that the lamp shell 322A can be made of high light permeability material, such as glass, acrylic, and etc., so as to allow the light generated by the light emitting elements 311A of the light emitting unit 31 A to pass through.

The circuit unit 50A is accommodated in the mounting shell 321A, such that after the lamp shell 322A is mounted on the mounting shell 321A, the circuit unit 50A can be covered and hidden in the internal environment 301A of the housing 32A of the acousto-optic device. Therefore, it can ensure that all electric circuits of the acousto-optic device will not be exposed, which further guarantees the security and reliability of the acousto-optic device in use.

The circuit unit 50A further comprises a circuit component 51A, an amplifier component 52A, and a communication component 53A. The amplifier component 52A, the communication component 53A, the main vibration speaker 21A, and the light emitting unit 31A are respectively electrically connected with the circuit component 51A. Besides, the amplifier component 52A, the communication component 53A, and the main vibration speaker 21A are interconnected. The communication component 53A can receive an audio signal and transmit it to the main vibration speaker 21A. Then the main vibration speaker 21 A can stir the air to vibrate it to sound in response to the audio signal input. It is worth mentioning that the communication component 53A can be a wireless communication module, such as Bluetooth module, Wi-Fi module, Li-Fi module, and etc. According to an embodiment of the present invention, the communication component 53A can be a Bluetooth module utilized when the acousto-optic device is at work. The communication component 53A can match with the Bluetooth module of a cellphone, such that the communication component 53A can receive audio signal from the cellphone and transmit it to the main vibration speaker 21A. Then the main vibration speaker 21A can stir the air to vibrate it to sound in response to the audio signal input and the sound generated by the main vibration speaker 21A can radiate to the external environment 302A of the acousto-optic device through the sound channel 303A provided on the lamp shell 322A.

The acoustic unit 20A further comprises a passive vibrator 22A and a vibration chamber 23A. The main vibration speaker 21A and the passive vibrator 22A share the vibration chamber 23A. When the main vibration speaker 21A stirs the air to vibrate it to sound in response to an audio signal input, the passive vibrator 22A vibrates in response to the vibration of the main vibration speaker 21 A, so as to stir the air to vibrate it to produce a subsidiary sound effect, such that the passive vibrator 22A can serve to enhance the low frequency sound effect of the acoustic unit 20A.

According to a preferred implementation of the present invention, the mounting shell 321A of the housing 32A further has at least two channels 304A. The channels 304A respectively communicate the internal environment 301A and the external environment 302A. When the passive vibrator 22A vibrates in response to the vibration of the main vibration speaker 21 A, the passive vibrator 22A in the internal environment 301A of the housing 32A stirs the air in the internal environment 301A to produce a subsidiary sound effect. The sound produced by the passive vibrator 22A will radiate from the internal environment 301A to the external environment 302A through the channel 304A.

In addition when the light emitting elements 311 A of the light emitting unit 31 A are generating light and the acoustic unit 20A is generating sound, they will generate lots of heat at the same time. The heat will increase the air temperature and air pressure in the internal environment 301A in the housing 32A. When the passive vibrator 22A is vibrating in response to the vibration of the main vibration speaker 21A, the passive vibrator 22A will stir the air in the internal environment 301C of the housing 32A to interchange with the air in the external environment 302A via the channels 304A, such that the air temperature of the internal environment 301A can be decreased and the air pressure of the external environment 302A and internal environment 301A can therefore be balanced as well. Hence, it is able to not only decrease the temperature of the internal environment 301A of the housing 32A when the acousto-optic device is in the service state, but also keep the air pressure of the external environment 302A and the internal environment 301A balanced, which ensures the purity of the sound effect of the acoustic unit 20A.

Preferably, the total ventilation volume of the channels 304A is greater than the air volume of the internal environment 301A of the housing 32A stirred by the vibration of the passive vibrator 22A in response to the vibration of the main vibration speaker 21 A, such that when the sound generated by stirring the air in the internal environment 301A of the housing 32A by the passive vibrator 22A passes through the channels 304A, the channels 304A will not cause wind noise on the acousto-optic device, which avoids the sounding acousto-optic device from whistling.

In addition, the acoustic unit 20A further comprises a speaker frame 24A. The mounting shell 321A comprises a mounting bed 3211A arranged thereon. The speaker frame 24A is mounted on the mounting bed 3211A of the mounting shell 321A. The main vibration speaker 21 A and the passive vibrator 22A are respectively arranged on the speaker frame 24A, so as to define the vibration chamber 23A among the main vibration speaker 21 A, the passive vibrator 22A, and the speaker frame 24A and to have the main vibration speaker 21A and the passive vibrator 22A share the vibration chamber 23A. It is worth mentioning that the main vibration speaker 21A and the passive vibrator 22A can be arranged on the same side of the speaker frame 24A or on the opposite sides of the speaker frame 24A. Referring to Fig. 6, according to this preferred implementation of the present invention, the main vibration speaker 21 A and the passive vibrator 22A are arranged on the opposite sides of the speaker frame 24A.

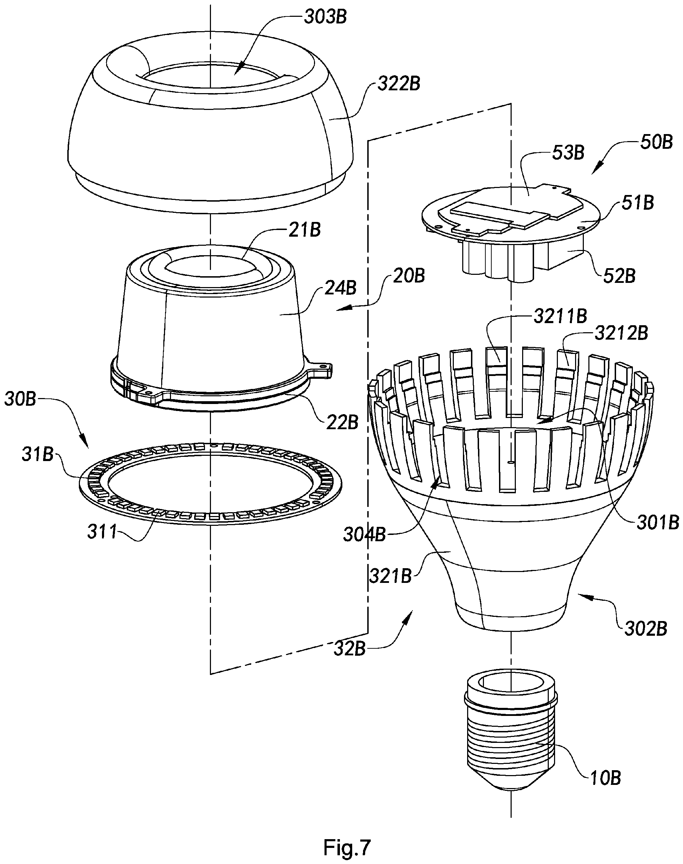

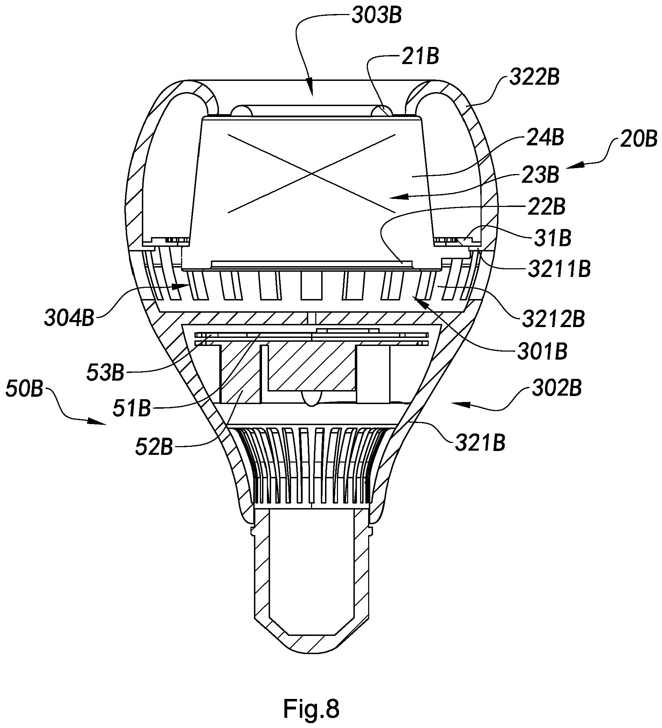

Referring to Figs. 7-8 of the drawings of the present invention, the acousto-optic device according to a third preferred embodiment of the present invention will be disclosed and illustrated in the following description. The acousto-optic device comprises a power-drawing unit 10B, an acoustic unit 20B, an illumination unit 30B, and a circuit unit 50B. The power-drawing unit 10B, the acoustic unit 20B, and the circuit unit 50B are respectively arranged on the illumination unit 30B. The acoustic unit 20B and the illumination unit 30B are respectively electrically connected with the circuit unit 50B. The circuit unit 50B is electrically connected with the power-drawing unit 10B. The power-drawing unit 10B is detachably mounted on a power-drawing base 100B, so as to obtain external electric power from the power-drawing base 100B and to affix the acousto-optic device on the power-drawing base 100B, wherein the circuit unit 50B can distribute and supply the electric power obtained from the power-drawing unit 10B to the acoustic unit 20B and the illumination unit 30B, so as to allow the acoustic unit 20B to generate sound and to allow the illumination unit 30B to generate light.

The illumination unit 30B comprises a light emitting unit 31B and a housing 32B. The housing 32B defines an internal environment 301B and an external environment 302B and further provides a sound channel 303B communicating the internal environment 301B and the external environment 302B. The acoustic unit 20B comprises a main vibration speaker 21 B. The main vibration speaker 21B and the light emitting unit 31B are respectively arranged in the housing 32B and respectively electrically connected with the circuit unit 50B. Besides, the power-drawing unit 10B is arranged outside of the housing 32B. When the power-drawing unit 10B is mounted on the power-drawing base 100B to obtain external electric power, the light generated by the light emitting unit 31B can radiate from the internal environment 301B of the housing 32B to the external environment 302B through part of the housing 32B. Also, the sound generated by stirring the air to vibrate by the main vibration speaker 21B in response to an audio signal input can radiate from the internal environment 301B of the housing 32B to the external environment 302B through the sound channel 303B.

The housing 32B further comprises a mounting shell 321B and a lamp shell 322B mounted on the mounting shell 321B, wherein the sound channel 303B is arranged on the lamp shell 322B. The power-drawing unit 10B, the acoustic unit 20B, and the light emitting unit 31B can be respectively arranged at mounting shell 321B. For instance, the power-drawing unit 10B can be arranged on an end of the mounting shell 321B, while the acoustic unit 20B and the light emitting unit 31B are respectively arranged on another end of the lamp shell 322B. Besides, the acoustic unit 20B and the main vibration speaker 21B are arranged correspondingly to the sound channel 303B of the lamp shell 322B. When the power-drawing unit 10B is mounted on the power-drawing base 100B to obtain external electric power, the light emitting unit 31B can generate light. The light can radiate from the internal environment 301B of the housing 32B to the external environment 302B through the housing 32B. Also, main vibration speaker 21B can stir the air to vibrate it to sound in response to an audio signal input. The sound can radiate from the internal environment 301B of the housing 32B to the external environment 302B through the sound channel 303B provided on the lamp shell 322B.

The acoustic unit 20B further comprises a passive vibrator 22B and a vibration chamber 23B. The main vibration speaker 21B and the passive vibrator 22B share the vibration chamber 23B. When the main vibration speaker 21B stirs the air to vibrate it to sound in response to an audio signal input, the passive vibrator 22B vibrates in response to the vibration of the main vibration speaker 21B, so as to stir the air to vibrate it to produce a subsidiary sound effect, such that the passive vibrator 22B can serve to enhance the low frequency sound effect of the acoustic unit 20B.

In addition, the acoustic unit 20B further comprises a speaker frame 24B. The mounting shell 321B comprises a mounting bed 3211B arranged thereon. The speaker frame 24B is mounted on the mounting bed 3211B of the mounting shell 321B. The main vibration speaker 21B and the passive vibrator 22B are respectively arranged on the speaker frame 24B, so as to define the vibration chamber 23B among the main vibration speaker 21B, the passive vibrator 22B, and the speaker frame 24B and to have the main vibration speaker 21 B and the passive vibrator 22B share the vibration chamber 23B. The light emitting unit 31B of the illumination unit 30B is arranged on the mounting bed 3211 B or on the speaker frame 24B. Further, the light emitting unit 31B further comprises at least a light emitting element 311B. For instance, the light emitting unit 31B may comprise one or more LED light emitting elements. The light emitting elements 311B can be arranged along the speaker frame 24B.

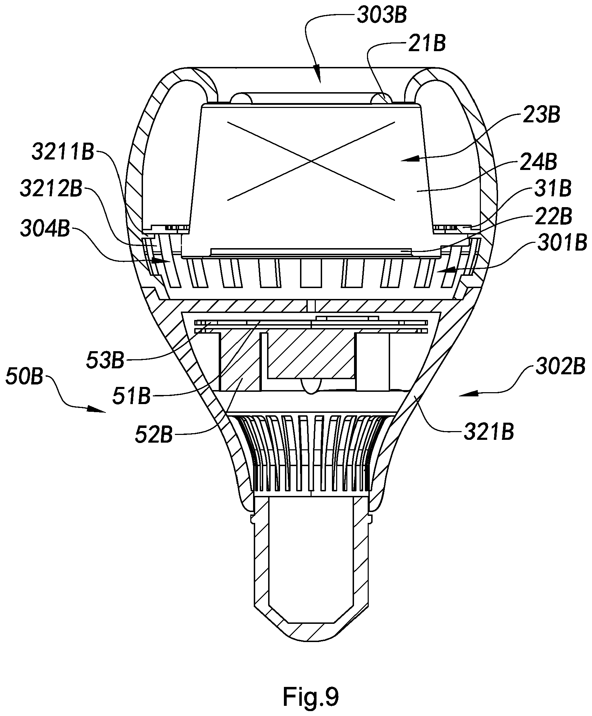

The mounting shell 321B comprises at least two bracing columns arranged thereon. The lamp shell 322B is mounted on the bracing columns 3212B of the mounting shell 321 B, so as to be supported by the bracing column 3212B of the mounting shell 321B. Channels 304B are formed between adjacent bracing columns 3212B. The channels 304B respectively communicate the internal environment 301B and the external environment 302B of the housing 32B. When the passive vibrator 22B vibrates in response to the vibration of the main vibration speaker 21 B, the passive vibrator 22B stirs the air in the internal environment 301B of the housing 32B so as to produce a subsidiary sound effect. The sound produced by the passive vibrator 22B will radiate from the internal environment 301B to the external environment 302B of the housing 32B through the channels 304B. According to this preferred embodiment of the present invention, the channels 304B may be formed between the lamp shell 322B and the mounting shell 321B after the lamp shell 322B is mounted on the mounting shell 321B rather than be provided on the mounting shell 321B. Referring to Fig. 9, according to another alternative mode of the present invention, the lamp shell 322B forms the bracing columns 3212B, such that after the lamp shell 322B is mounted on the mounting shell 321B, the channels 304B can also be provided between lamp shell 322B and the mounting shell 321B.

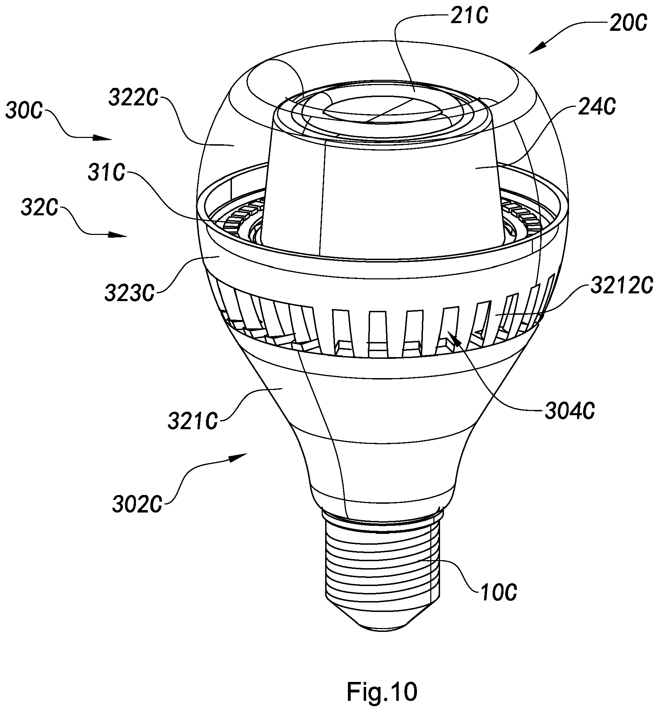

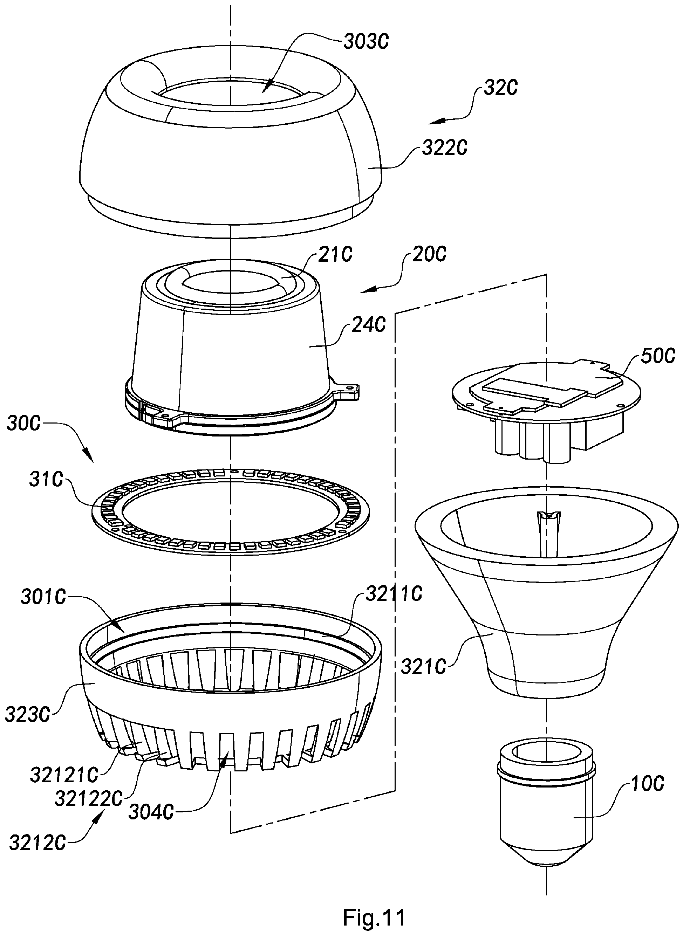

Referring to Figs. 10-13 of the drawings of the present invention, the acousto-optic device according to a fourth preferred embodiment of the present invention will be disclosed and illustrated in the following description. The acousto-optic device comprises a power-drawing unit 10C, an acoustic unit 20C, and an illumination unit 30C. The power-drawing unit 10C and the acoustic unit 20C are respectively arranged on the )illumination unit 30C. The acoustic unit 20C and the illumination unit 30C are respectively electrically connected with the power-drawing unit 10C. The power-drawing unit 10C is detachably mounted on a power-drawing base 100C so as to obtain external electric power from the power-drawing base 100C to actuate the acoustic unit 20C and the illumination unit 30C into the service state. Person skilled in the art should be able to understand that acoustic unit 20C and the illumination unit 30C can share one electric circuit, such that the stability and reliability of the acousto-optic device can be enhanced.

Further, the acousto-optic device comprises a circuit unit 50C electrically connected with the power-drawing unit 10C. The acoustic unit 20C and the illumination unit 30C are respectively electrically connected with the circuit unit 50C, such that when the power-drawing unit 10C is mounted on the power-drawing base 100C to obtain external electric power, the circuit unit 50C can distribute and supply the electric power from the power-drawing unit 10C to the acoustic unit 20C and the illumination unit 30C respectively, so as to allow the acoustic unit 20C to generate sound and allow the illumination unit 30C to generate light.

The illumination unit 30C comprises a light emitting unit 31C and a housing 32C. The housing 32C defines an internal environment 301C and an external environment 302C and further provides a sound channel 303C communicating the internal environment 301C and the external environment 302C of the housing 32C. The power-drawing unit 10C, the acoustic unit 20C, and the light emitting unit 31C can be respectively arranged at different positions of the housing 32C. For instance, the power-drawing unit 10C can be arranged on an end of the housing 32C, while the acoustic unit 20C and the light emitting unit 31C are respectively arranged on another end of the housing 32C. According to a specific implementation of the present invention, the arrangement of the acousto-optic device can become a lamp-like structure.

The acoustic unit 20C comprises a main vibration speaker 21C. The main vibration speaker 21C and the light emitting unit 31C are respectively arranged in the housing 32C and respectively electrically connected with the circuit unit 50C. When the power-drawing unit 10C is mounted on the power-drawing base 100C to obtain external electric power, the light generated by the light emitting unit 31C can radiate from the internal environment 301C of the housing 32C to the external environment 302C through part of the housing 32C. Also, the sound generated by stirring the air to vibrate by the main vibration speaker 21C in response to an audio signal input can radiate from the internal environment 301C of the housing 32C to the external environment 302C through the sound channel 303C provided on the housing 32C.

The housing 32C further comprises a mounting shell 321C, a lamp shell 322C, and a bracing member 323C. The mounting shell 321C and the lamp shell 322C are respectively arranged on the two sides of the bracing member 323C. That is to say, the bracing member 323C is utilized to connect the mounting shell 321C and the lamp shell 322C. Besides, the sound channel 303C is provided on the lamp shell 322C. The power-drawing unit 10C and the circuit unit 50C are respectively arranged at the outside and inside of the mounting shell 321C, so as to cover the circuit unit 50C in the internal environment 301C of the housing 32C. Therefore, the acousto-optic device has no electric circuit exposed in the external environment 302C of the housing 32C, which makes the acousto-optic device safer. The bracing member 323C provides a mounting bed 3211C. The acoustic unit 20C comprises a speaker frame 24C. The main vibration speaker 21C is arranged on the speaker frame 24C. The speaker frame 24C and the light emitting unit 31C are respectively arranged on the mounting bed 3211C of the bracing member 323C. The light emitting unit 31C comprises at least a light emitting element 311C. The light emitting elements 311C of the light emitting unit 31C can be surroundingly arranged around the main vibration speaker 21C. The lamp shell 322C is arranged along the light path of the light emitting unit 31C to allow the light generated by the light emitting elements 311C of the light emitting unit 31C to pass through. When the power-drawing unit 10C is mounted on the power-drawing base 100C to obtain external electric power, the light emitting unit 31C can generate light and radiate it from the internal environment 301C to the external environment 302C through the lamp shell 322C. Correspondingly, the main vibration speaker 21C stirs the air to vibrate to sound in response to an audio signal input. The sound produced by the main vibration speaker 21C will radiate from the internal environment 301C of the housing 32C to the external environment 302C of the housing 32C through the sound channel 303C.

The acoustic unit 20C further comprises a passive vibrator 22C and a vibration chamber 23C. The main vibration speaker 21C and the passive vibrator 22C share the vibration chamber 23C. When the main vibration speaker 21C stirs the air to vibrate it to sound in response to an audio signal input, the passive vibrator 22C vibrates in response to the vibration of the main vibration speaker 21C, so as to stir the air to vibrate it to produce a subsidiary sound effect, such that the passive vibrator 22C can serve to enhance the low frequency sound effect of the acoustic unit 20C. The main vibration speaker 21C and the passive vibrator 22C are respectively arranged on the speaker frame 24C, so as to define the vibration chamber 23C among the main vibration speaker 21C, the passive vibrator 22C, and the speaker frame 24C and to have the main vibration speaker 21C and the passive vibrator 22C share the vibration chamber 23C.

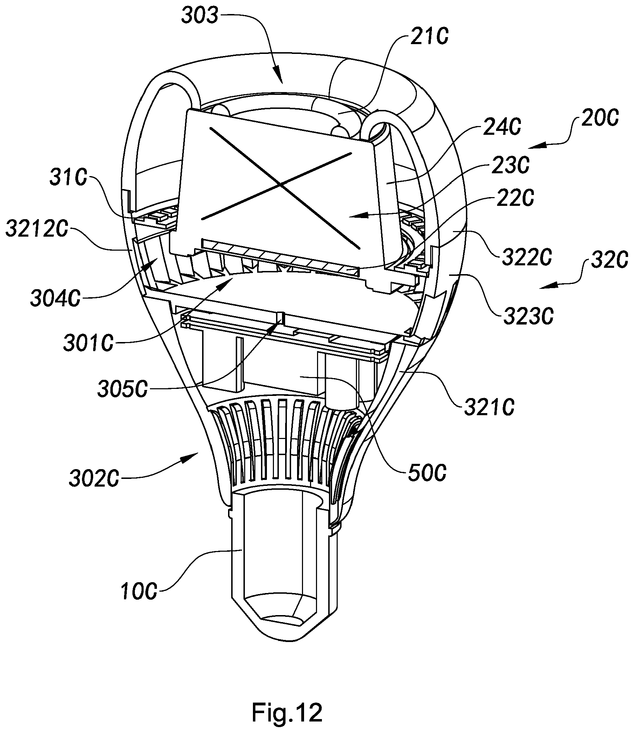

It is worth mentioning that the main vibration speaker 21C and the passive vibrator 22C can be arranged on the same side of the speaker frame 24C or on the opposite sides of the speaker frame 24C. Referring to Fig. 12, according to this preferred implementation of the present invention, the main vibration speaker 21C and the passive vibrator 22C are arranged on the opposite sides of the speaker frame 24.

The bracing member 323C comprises at least two channels 304C. The channels 304C respectively communicate the internal environment 301C and the external environment 302C of the housing 32C. When the passive vibrator 22C vibrates in response to the vibration of the main vibration speaker 21C, the passive vibrator 22C stirs the air in the internal environment 301C of the housing 32C so as to produce a subsidiary sound effect. The sound produced by the passive vibrator 22C will radiate from the internal environment 301C to the external environment 302C of the housing 32C through the channels 304C.

The bracing member 323C further has a wire channel 305C provided thereon allowing wire to pass through to be electrically connected with the circuit unit 50C, the light emitting unit 31C, and the main vibration speaker 21C, so as to provide electric power to the light emitting unit 31C and the main vibration speaker 21C.

The light emitting elements 311C of the light emitting unit 31C are arranged on the bracing member 323C and provided on the circumference direction of the main vibration speaker 21C. When the light emitting elements 311C of the light emitting unit 31C are generating light, they will generate lots of heat at the same time. The heat will be transferred through the bracing member 323C and radiate in the internal environment 301C and the external environment 302C. Because the space of the internal environment 301C is smaller, the heat will increase the air temperature and air pressure of the internal environment 301C. During the sounding process of the passive vibrator 22C, the passive vibrator 22C will stir the air of the internal environment to vibrate, so as to have the air of the internal environment 301C to interchange with the air of the external environment 302C via the channels 304C, such that the air temperature of the internal environment 301C of the housing 32C can be decreased and the air pressure of the external environment 302C and internal environment 301C of the housing 32C can be balanced. By so, it is able to not only decrease the temperature of the acousto-optic device in the service state, but also keep the air pressure of the external environment 302C and the internal environment 301C balanced. Besides, it can ensure the purity of, especially, the low frequency sound effect of the acoustic unit 20C.

It is worth mentioning that the bracing member 323C can be made of metallic material or alloy material that have better heat dispersion performance. For instance, according to a preferred embodiment of the present invention, the bracing member 323C can be made of aluminum alloy, so as to further enhance the heat dissipation performance of the acousto-optic device.

Preferably, the total ventilation volume of the channels 304C is greater than the air volume of the internal environment 301C stirred by the vibration of the passive vibrator 22C in response to the vibration of the main vibration speaker 21C, such that when the sound generated by stirring the air in the internal environment 301C by the passive vibrator 22C passes through the channels 304C, the channels 304C will not cause wind noise on the acousto-optic device, which avoids the sounding acousto-optic device from whistling.

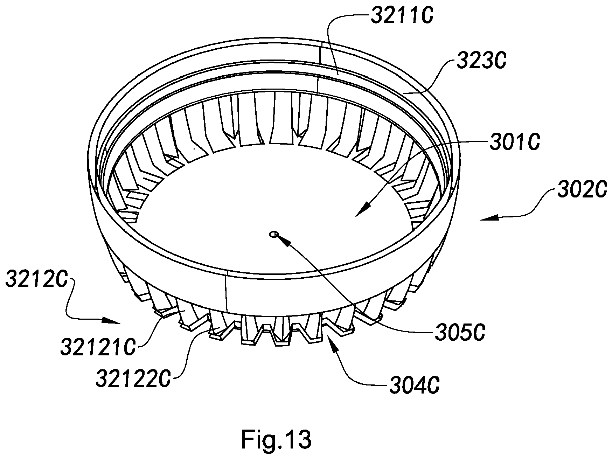

Referring to Fig. 13, the bracing member 232C provides two sets of bracing columns 3212C, which are a first bracing column set 32121C, and a second bracing column set 32122C. The bracing columns of the first bracing column set 32121C and the bracing columns of the second bracing column set 32122C are alternately arranged, so as to define the channels 304C between the adjacent bracing columns. Preferably, the distance between each adjacent bracing columns are the same, so as to guarantee the sound effect of the acoustic unit 20C. According to this preferred implementation of the present invention, the dimensions of the bracing columns of the first bracing column set 32121C gradually becomes smaller from the direction of the internal environment 301C to the direction of the external environment 302C, while the dimensions of the bracing columns of the second bracing column set 32122C gradually becomes larger from the direction of the internal environment to the direction of the external environment. It is worth mentioning that the present invention also provides a thermal system of the acousto-optic device. The acousto-optic device comprises the illumination unit 30. The illumination unit 30 comprises the housing 32 and a light emitting unit 31 arranged on the housing 32. The housing 32 provides a channel 304 arranged thereon. The thermal system of the acousto-optic device further comprises an acoustic unit 20. The acoustic unit 20 is arranged on the housing 32. When the acoustic unit 20 responses to an audio signal input, it will stir the air of the internal environment 301 to pass through the channel 304 and to interchange with the air of the external environment 302, such that it can decrease the internal temperature of the acousto-optic device and further balance the air pressure of the internal environment 301 and external environment 302 of the housing 32.

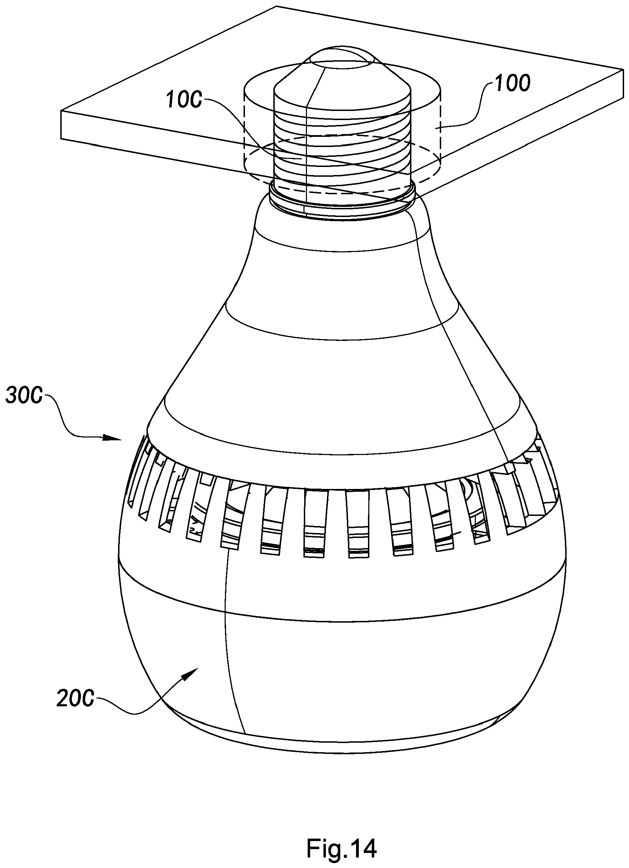

Figure 14 illustrated a perspective view of the acousto-optic device in a service state. The power-drawing base 100 is embodied as a lamp mounting base preset on the ceiling of the building. The type of the power-drawing unit 10 of the acousto-optic device matches the type of the lamp mounting base. After the power-drawing unit 10 is mounted on the lamp mounting base, the power-drawing unit 10 can affix the acousto-optic device at the position on the ceiling of the building and the acousto-optic device can obtain electric power from the power-drawing base 100 through the power-drawing unit 10. Person skilled in the art should be able to understand that the acousto-optic device does not have to occupy ground or countertop space. Instead, it is affixed on the ceiling of the building by through the power-drawing unit 10 mounted on the power-drawing base 100. Therefore, the user will not bump the acousto-optic device when moving in the space of the building.

When the acousto-optic device is utilized, the power-drawing unit 10 can obtain electric power from the power-drawing base 100 and distribute and supply the electric power to the illumination unit 30 and the acoustic unit 20 through the circuit unit 50. The light emitting unit 31 of the illumination unit 30 can generate light. The user may also connect any electronic device that can generate audio signal, such as a cellphone and etc., with the acousto-optic device, so as to allow the main vibration speaker 21 of the acoustic unit 20 to vibrate to sound in response to the audio signal input. Then, because the acousto-optic device is affixed on the power-drawing base 100 through the power-drawing unit 10, the vibration of sounding of the main vibration speaker 21 will not cause the oscillation of the acousto-optic device, which guarantees the purity of the sound effect provided by the acousto-optic device.

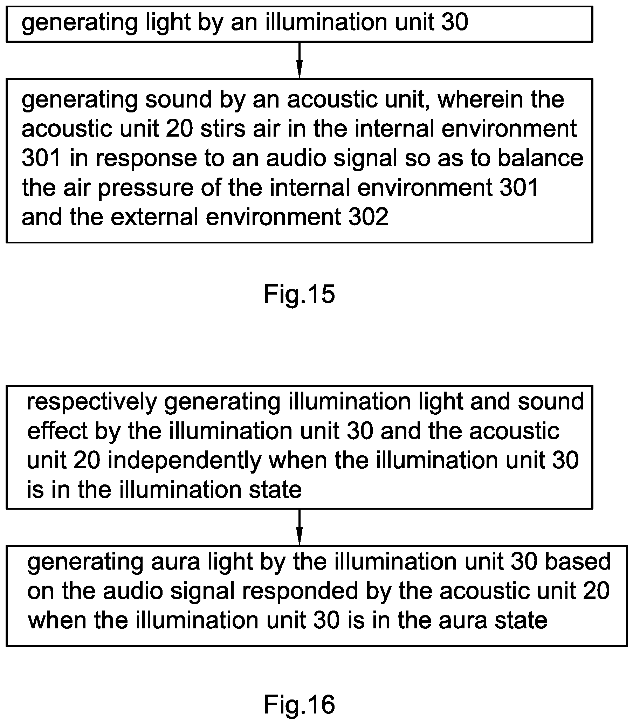

Referring to Fig. 15, the present invention further provide a method for the acousto-optic device to produce light and sound, wherein the acousto-optic device defines the internal environment 301 and the external environment 302, wherein the method comprises the following steps:
(a) generating light by an illumination unit 30; and
(b) generating sound by an acoustic unit, wherein the acoustic unit 20 stirs air in the internal environment 301 in response to an audio signal so as to balance the air pressure of the internal environment 301 and the external environment 302.

According to an embodiment of the present invention, at least a channel 304 is formed on the acousto-optic device in the step (b), wherein the acoustic unit 20 stirs the air of the internal environment 301 to pass through the channel 304 and interchange with the air of the external environment 302, wherein the channels 304 communicate the internal environment 301 and the external environment 302 of the housing 32. Referring to Fig. 16, the present invention further provides an application method of the acousto-optic device, wherein the acousto-optic device comprises the illumination unit 30 and the acoustic unit 20. The illumination unit 30 has an illumination state and an aura state. The illumination unit 30 is adaptable for switching between the illumination state and the aura state. The application method comprises the following steps.
(A) respectively generating illumination light and sound effect by the illumination unit 30 and the acoustic unit 20 independently when the illumination unit 30 is in the illumination state; and
(B) generating aura light by the illumination unit 30 based on the audio signal responded by the acoustic unit 20 when the illumination unit 30 is in the aura state.

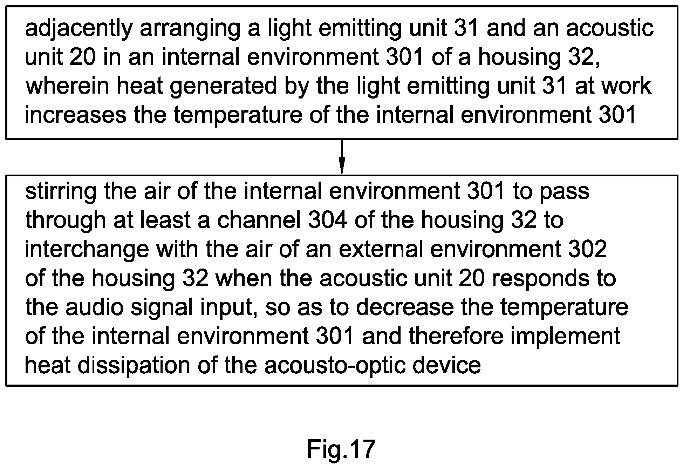

Referring to Fig. 17, the present invention further provides a heat dissipation method of an acousto-optic device, comprising the following steps:
(i) adjacently arranging a light emitting unit 31 and an acoustic unit 20 in an internal environment 301 of a housing 32, wherein heat generated by the light emitting unit 31 at work increases the temperature of the internal environment 301; and
(ii) stirring the air of the internal environment 301 to pass through at least a channel 304 of the housing 32 to interchange with the air of an external environment 302 of the housing 32 when the acoustic unit 20 responds to the audio signal input, so as to decrease the temperature of the internal environment 301 and therefore implement heat dissipation of the acousto-optic device.

Preferably, the light emitting unit 31 is arranged on a speaker frame 24 of the acoustic unit 20 in the step (i), such that when a main vibration speaker 21 of the acoustic unit 20 vibrate in response to an audio signal input, a passive vibrator 22 of the acoustic unit 20 can vibrate in response to the vibration of the main vibration speaker 21, so as to utilize the passive vibrator 22 to stir the air of the internal environment 301 to pass through each the channel 304 to interchange with the air of an external environment 302 in the step (ii).

One skilled in the art will understand that the embodiment of the present invention as shown in the drawings and described above is exemplary only and not intended to be limiting.

Objectives of the present invention are completely and effectively implemented. Notions of the functions and structures of the present invention have been shown and described in the embodiments, whereas implementations of the present invention may have modifications or changes in any ways without going against the above notions.

## Claims

1. An acousto-optic device, comprising:
a power-drawing unit; and
at least an acoustic unit, wherein each of said acoustic units comprises a main vibration speaker electrically connected with the power-drawing unit, wherein said power-drawing unit is detachably installed on a power-drawing base to allow said main vibration speaker to draw electric energy therefrom, wherein when said main vibration speaker vibrates to sound in response to an audio signal, said power-drawing unit installed on the power-drawing base prevents said acoustic units from oscillation, so as to guarantee the sound effect of said acousto-optic device.

2. The acousto-optic device, as recited in claim 1, further comprising an illumination unit comprising a light emitting unit electrically connected with said power-drawing unit.

3. The acousto-optic device, as recited in claim 2, wherein said power-drawing unit and said light emitting unit are respectively arranged on said main vibration speaker.

4. The acousto-optic device, as recited in claim 1 or 2, wherein said acoustic unit further comprises at least a passive vibrator and a vibration chamber, wherein each said passive vibrator and said main vibration speaker share said vibration chamber, wherein when said main vibration speaker vibrates to sound in response to an audio signal, each said passive vibrator vibrates in response to the vibration of said main vibration speaker, so as to produce a subsidiary sound effect.

5. The acousto-optic device, as recited in claim 4, wherein said acoustic unit further comprises a speaker frame, wherein said main vibration speaker and each said passive vibrator are respectively arranged on said speaker frame, so as to define said vibration chamber among said main vibration speaker, each said passive vibrator, and said speaker frame, wherein said power-drawing unit is arranged on said speaker frame.

6. The acousto-optic device, as recited in claim 2, further comprising a mounting body, wherein said power-drawing unit, said main vibration speaker, and said light emitting unit are respectively arranged on said mounting body.

7. The acousto-optic device, as recited in claim 1, further comprising an illumination unit, wherein said illumination unit comprises a housing defining an internal environment and an external environment and providing a sound channel, wherein said sound channel communicates said internal environment and said external environment, wherein said power-drawing unit is arranged on said housing and located in said external environment, wherein said main vibration speaker is arranged in said internal environment of said housing and corresponded to said sound channel.

8. The acousto-optic device, as recited in claim 7, wherein said housing further comprises at least a channel formed thereon, wherein each said channel respectively communicates said internal environment and said external environment, wherein said acoustic unit further comprises a passive vibrator and a vibration chamber, wherein said passive vibrator is arranged in said internal environment of said housing, wherein said passive vibrator and said main vibration speaker share said vibration chamber, wherein when said main vibration speaker vibrates to sound in response to an audio signal input, said passive vibrator vibrates in response to the vibration of said main vibration speaker, so as to produce a subsidiary sound effect, wherein said subsidiary sound effect produced by said passive vibrator radiates from said internal environment to said external environment through each said channel.

9. The acousto-optic device, as recited in claim 8, wherein said housing has a mounting bed arranged on the inner wall thereof, wherein said acoustic unit comprises a speaker frame mounted on said mounting bed, wherein said main vibration speaker and said passive vibrator are respectively arranged on said speaker frame, so as to define said vibration chamber among said main vibration speaker, said passive vibrator, and said speaker frame.

10. The acousto-optic device, as recited in claim 8, wherein said illumination unit further comprises a light emitting unit arranged on the inner wall of said housing or said speaker frame and electrically connected with said power-drawing unit.

11. The acousto-optic device, as recited in claim 10, wherein said housing further comprises a transparent lamp shell and a mounting shell, wherein said mounting shell has said channel arranged thereon, wherein said speaker frame is arranged in said mounting shell or in said lamp shell, wherein said power-drawing unit is arranged outside of said mounting shell, wherein said lamp shell is arranged on said mounting shell, so as to provide said acoustic unit and said light emitting unit in said internal environment defined between said lamp shell and said mounting shell, wherein light generated by said light emitting unit passes through said lamp shell to radiate from said internal environment to said external environment.

12. The acousto-optic device, as recited in claim 10, wherein said housing further comprises a transparent lamp shell and a mounting shell, wherein said mounting shell comprises at least two bracing columns arranged thereon, wherein said speaker frame is arranged in said mounting shell or in said lamp shell, wherein said power-drawing unit is arranged outside of said mounting shell, wherein said lamp shell is mounted on said bracing columns of said mounting shell, so as to define said channel between adjacent said bracing columns, such that said acoustic unit and said light emitting unit are provided in said internal environment defined between said lamp shell and said mounting shell, wherein light generated by said light emitting unit passes through said lamp shell to radiate from said internal environment to said external environment.

13. The acousto-optic device, as recited in claim 10, wherein said housing further comprises a transparent lamp shell and a mounting shell, wherein said lamp shell comprises at least two bracing columns arranged thereon, wherein said speaker frame is arranged in said mounting shell or in said lamp shell, wherein said power-drawing unit is arranged outside of said mounting shell, wherein said mounting shell is mounted on said bracing columns of said lamp shell, so as to define said channel between adjacent said bracing columns, such that said acoustic unit and said light emitting unit are provided in said internal environment defined between said lamp shell and said mounting shell, wherein light generated by said light emitting unit passes through said lamp shell to radiate from said internal environment to said external environment.

14. The acousto-optic device, as recited in claim 10, wherein said housing further comprises a transparent lamp shell, a mounting shell, and a bracing member, wherein said power-drawing unit is arranged outside of said mounting shell, wherein said bracing member comprises at least two bracing columns arranged on a side thereof, wherein said mounting shell is arranged on another side of said bracing member, wherein said speaker frame is arranged in said lamp shell or in said bracing member, wherein said lamp shell is mounted on said bracing columns of said bracing member, so as to define said channel between adjacent said bracing columns, such that said acoustic unit and said light emitting unit are provided in said internal environment defined between said lamp shell and said bracing member, wherein light generated by said light emitting unit passes through said lamp shell to radiate from said internal environment to said external environment.

15. The acousto-optic device, as recited in claim 10, wherein said housing further comprises a transparent lamp shell, a mounting shell, and a bracing member, wherein said lamp shell comprises at least two bracing columns arranged thereon, wherein said power-drawing unit is arranged outside of said mounting shell, wherein said mounting shell is arranged on a side of said bracing member, wherein another side of said bracing member is mounted on said bracing columns of said lamp shell, so as to define said channel between adjacent said bracing columns, such that said speaker frame is arranged in said lamp shell or in said bracing member, such that said acoustic unit and said light emitting unit are provided in said internal environment defined between said lamp shell and said bracing member, wherein light generated by said light emitting unit passes through said lamp shell to radiate from said internal environment to said external environment.

16. The acousto-optic device, as recited in any of claim 11-15, wherein said bracing columns form a first bracing column set and a second bracing column set, wherein each said bracing column of said first bracing column set and each said bracing column of said second bracing column set are alternately arranged, wherein the dimensions of said bracing columns of said first bracing column set gradually becomes smaller from the direction of said internal environment to the direction of said external environment, while the dimensions of said bracing columns of said second bracing column set gradually becomes larger from the direction of said internal environment to the direction of said external environment.

17. The acousto-optic device, as recited in any of claim 10-15, further comprising a circuit unit arranged in said internal environment, wherein said circuit unit comprises a circuit component electrically connected with said power-drawing unit, said main vibration speaker, and said light emitting unit respectively.

18. The acousto-optic device, as recited in claim 17, wherein said circuit unit further comprises an amplifier component connected with said main vibration speaker.

19. A heat dissipation method of an acousto-optic device, comprising the following steps:
(i) adjacently arranging a light emitting unit and an acoustic unit in an internal environment of a housing, wherein heat generated by the light emitting unit at work increases the temperature of the internal environment; and
(ii) stirring the air of the internal environment to pass through at least a channel of the housing to interchange with the air of an external environment of the housing when the acoustic unit responds to the audio signal input, so as to decrease the temperature of the internal environment and therefore implement heat dissipation of the acousto-optic device.

20. The heat dissipation method, as recited in claim 19, wherein the light emitting unit is arranged on a speaker frame of the acoustic unit in said step (i), such that when a main vibration speaker of the acoustic unit vibrate in response to an audio signal input, a passive vibrator of the acoustic unit can vibrate in response to the vibration of the main vibration speaker, so as to utilize the passive vibrator to stir the air of the internal environment to pass through each the channel to interchange with the air of an external environment in said step (ii).

21. The heat dissipation method, as recited in claim 20, wherein the main vibration speaker and the passive vibrator are arranged on the opposite side of the speaker frame, wherein the light emitting unit is adjacent to the passive vibrator.

22. The heat dissipation method, as recited in claim 20, wherein the main vibration speaker and the passive vibrator share a vibration chamber, so as to allow the passive vibrator to vibrate in response to the vibration of the main vibration speaker.
